(19) **Europäisches Patentamt**
**European Patent Office**
**Office européen des brevets**

(11) Veröffentlichungsnummer: **0 277 546 B1**

(12) **EUROPÄISCHE PATENTSCHRIFT**

(45) Veröffentlichungstag der Patentschrift: **17.06.92**

(51) Int. Cl.⁵: **H01L 25/04**, H01L 23/58, H01L 23/52

(21) Anmeldenummer: **88100792.6**

(22) Anmeldetag: **20.01.88**

(54) **Halbleiteranordnung mit mindestens einem Halbleiterkörper.**

(30) Priorität: **21.01.87 DE 3701650**

(43) Veröffentlichungstag der Anmeldung:
**10.08.88 Patentblatt 88/32**

(45) Bekanntmachung des Hinweises auf die
Patenterteilung:
**17.06.92 Patentblatt 92/25**

(84) Benannte Vertragsstaaten:
**CH DE FR GB IT LI**

(56) Entgegenhaltungen:
**EP-A- 0 042 987**
**EP-A- 0 221 399**
**DE-A- 3 516 995**
**US-A- 4 237 522**

**PATENT ABSTRACTS OF JAPAN, Band 9, Nr.
212 (E-339)[1935], 29. August 1985 & JP-A-60
74 557**

(73) Patentinhaber: **SIEMENS AKTIENGESELL-
SCHAFT**
**Wittelsbacherplatz 2**
**W-8000 München 2(DE)**

(72) Erfinder: **Amann, Heinz**
**Fasanenstrasse 100**
**W-8025 Unterhaching(DE)**
Erfinder: **Lorenz, Leo, Dr.-Ing.**
**Max-Lörr-Strasse 14**
**W-8014 Neubiberg(DE)**

## Beschreibung

Die Erfindung bezieht sich auf eine Halbleiteranordnung mit den Merkmalen:

a) auf einer der Seiten eines isolierenden Substrats sind mindestens zwei elektrisch voneinander getrennte, den Laststrom führende Leiterbahnen angeordnet,

b) die Leiterbahnen liegen einander parallel und benachbart,

c) auf einer der Leiterbahnen sind Halbleiterkörper angeordnet, die über einen Kontakt mit der Leiterbahn verbunden sind,

d) die andere Leiterbahn ist elektrisch mit einem anderen Kontakt des Halbleiterkörpers verbunden,

e) zwei den Laststrom führende Anschlußleiter sind elektrisch jeweils mit einer der beiden Leiterbahnen verbunden.

Eine Halbleiteranordnung der oben bechriebenen Art ist Gegenstand des älteren europäischen Patents EP-A-0 265 833, ein Dokument unter 54(3) EPÜ. Ein Ausführungsbeispiel zeigt, daß die den Laststrom führenden Anschlußleiter an einander entgegengesetzten Enden des Substrats angeordnet sind. Damit bilden sie eine relativ hohe Induktivität im Lastkreis, wodurch beim Abschalten der Halbleiteranordnung mit hoher Steilheit des Laststroms eine hohe Spannung induziert wird, die zur Zerstörung der Halbleiterbauelemente führen kann.

Ziel der vorliegenden Erfindung ist es, die Induktivität des Hauptstromkreises zu verringern.

Dies wird durch folgendes Merkmal erreicht:
Die Anschlußleiter sind dicht beieinander und mindestens teilweise parallel zueinander angeordnet und an parallel liegenden Abschnitten der Leiterbahnen befestigt.

In der US-Patentschrift US-A-4,237,522 ist eine Halbleiteranordnung mit mehreren Halbleiterkörpern und mehreren parallel liegenden Halbleiterkörpern und mehreren parallel liegenden Anschlußleitern beschrieben. Diese Anschlußleiter sind mit einer Vielzahl in einer ersten Ebene liegenden, parallelen Anschlußleitern und mit einer Vielzahl rechtwinklig dazu liegenden, in einer zweiten Leiterebene angeordneten Leiterbahnen verbunden. Die Anschlußleiter sind zum Teil abgeschirmt angeordnet. Hierbei handelt es sich um eine komplexe VLSI-Anordnung, deren Stromverläufe nicht im einzelnen angegeben sind. Eine solche Anordnung ist jedoch für Leistungszwecke nicht brauchbar.

Weiterbildungen der Erfindung sind Gegenstand der Unteransprüche.

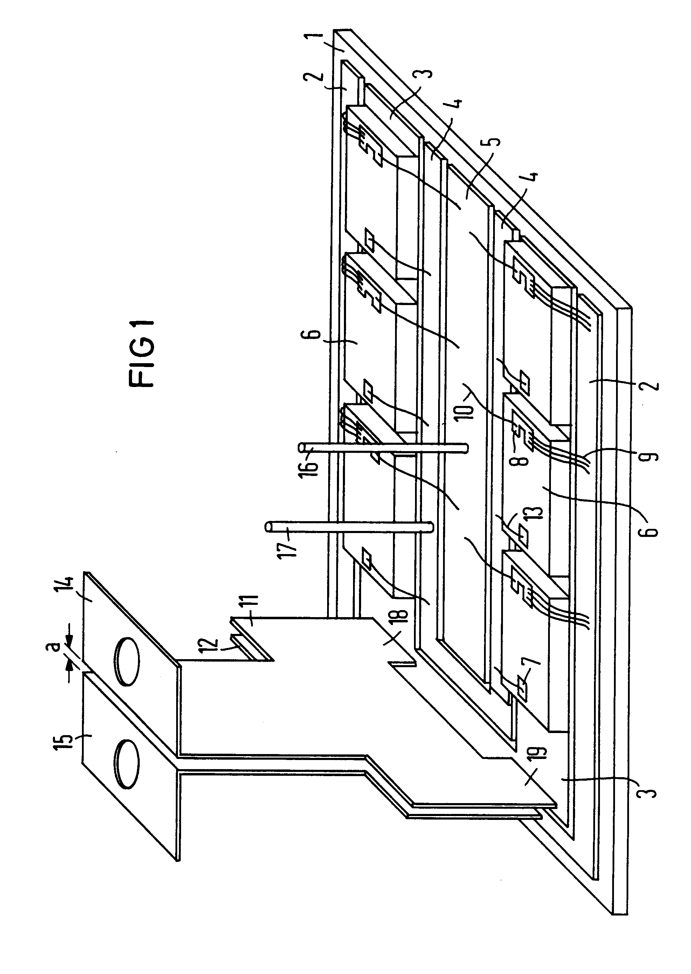

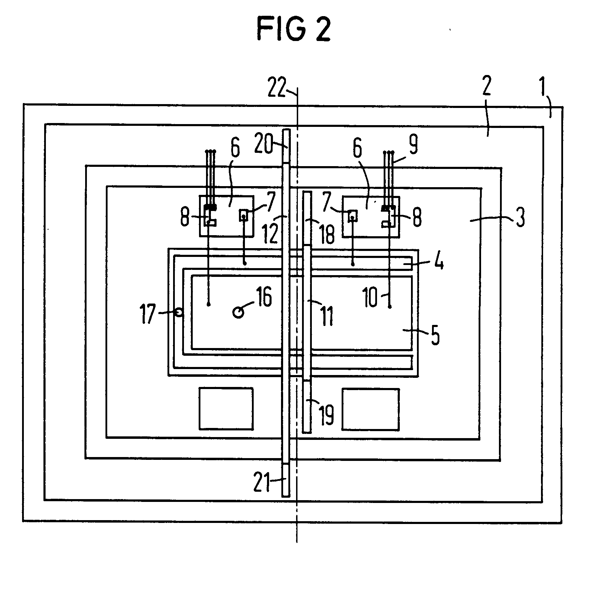

Die Erfindung wird anhand zweier Ausführungsbeispiele in Verbindung mit den Figuren 1 und 2 näher erläutert. Es zeigen:

Figur 1 eine perspektivische Ansicht eines ersten Ausführungsbeispiels und

Figur 2 die Aufsicht auf ein zweites Ausführungsbeispiel.

Die Halbleiteranordnung nach Figur 1 ist auf einem Substrat 1 aufgebaut. Das Substrat besteht aus einem gut isolierenden und thermisch gut leitenden Werkstoff wie z. B. Aluminiumoxid oder Berylliumoxid. Auf dem Substrat sind Leiterbahnen 2, 3, 4 und 5 angeordnet. Die Leiterbahnen 2 und 3 sind U-förmig ausgebildet; beide Leiterbahnen sind ineinander verschachtelt. Auf der Leiterbahn 3 sind Halbleiterkörper 6 angeordnet und mit den Leiterbahnen stromleitend verbunden. Die Halbleiterkörper können beispielsweise Leistungs-MOSFET's oder auch Bipolartransistoren sein. Im vorliegenden Fall wird davon ausgegangen, daß die Halbleiterkörper MOSFET's sind. Sie weisen auf der der Leiterbahn 3 abgekehrten Seite Gatekontakte 7 und Sourcekontakte 8 auf. Der Drainkontakt liegt auf der unteren Seite und ist mit der Leiterbahn 3 verbunden. Die Sourcekontakte 7 sind mit der Leiterbahn 4 über Bonddrähte 13 verbunden. Die Sourcekontakte 8 stehen mit der Leiterbahn 2 über Bonddrähte 9 in Verbindung. Die Sourcekontakte 8 sind außerdem über Bonddrähte 10 mit der vierten Leiterbahn 5 verbunden.

Die Leiterbahnen 2 und 3 sind aus Gründen einer möglichst geringen Induktivität im Lastkreis nahe beieinander angeordnet. Ihr Abstand ist aber so bemessen, daß die geforderte elektrische Spannungsfestigkeit gewährleistet ist. Die Leiterbahnen 2 und 3 liegen außerdem einander parallel. An den ebenfalls einander parallelliegenden Jochen der beiden U-förmigen Leiterbahnen 2 und 3 ist je ein Anschlußleiter 11 bzw. 12 angebracht, z. B. angelötet. Die Anschlußleiter 11, 12 sind einander bis auf ihre zum Anschluß an eine äußere Leitung bestimmte Flächen 14, 15 parallel. Ihr Abstand a ist ebenso wie der Abstand zwischen den beiden Leiterbahnen 2 und 3 möglichst gering gewählt derart, daß die elektrische Spannungsfestigkeit noch gewährleistet ist.

Durch den beschriebenen Aufbau läßt sich die Induktivität des Hauptstromkreises gegenüber der eingangs erwähnten Halbleiteranordnung etwa halbieren. Damit wird auch die beim Abschalten des Stroms auftretende induktive Spannung halbiert.

Die Leiterbahnen 4 und 5 sind mit einem Gateanschluß 17 bzw. einem Source-Hilfsanschluß 16 verbunden. Die MOSFET werden durch eine zwischen die Anschlüsse 16 und 17 angelegte Spannung gesteuert. Der Steuerkreis ist somit induktiv weitgehend vom Laststromkreis entkoppelt, so daß der Laststromanstieg nur geringen Einfluß auf das Einschaltverhalten der Halbleiteranordnung hat.

Die trotz des geringen Abstandes a zwischen den Anschlußleitern 11, 12 bestehende Induktivität kann dadurch teilweise kompensiert werden, daß der Zwischenraum zwischen den Anschlußleitern mit einem Dielektrikum gefüllt wird, dessen relative Dielektrizitätskonstante größer als 1 ist. Hier können die für Kondensatoren verwendbaren Materialien Verwendung finden. Zusätzlich oder ausschließlich kann eine Isolierstoffolie zwischen den beiden Anschlußleitern angeordnet sein.

Es empfiehlt sich aus Gründen einer geringen Induktivität, die Anschlußleiter möglichst kurz zu halten. Sie stehen daher vorzugsweise senkrecht zur Oberfläche des Substrats 1.

Weist die Halbleiteranordnung mehrere Halbleiterkörper auf, so können die Anschlußleiter 11, 12, wie in Figur 2 dargestellt symmetrisch auf dem Substrat 1 und den Leiterbahnen 2, 3 angeordnet sein. Im Ausführungsbeispiel nach Figur 2 sind die Leiterbahnen 2, 3 in sich geschlossene Ringe, die jeweils zu einer Symmetrieachse 22 spiegelsymmetrisch ausgebildet sind. Ebenso sind die Halbleiterkörper 6 symmetrisch zur Symmetrieachse 22 auf der Leiterbahn 3 verteilt. Die Anschlußleiter 11, 12 sind beidseitig der Symmetrieachse angeordnet. Zur Vermeidung von Kurzschlüssen haben die Anschlußleitern 11, 12 Füße 18, 19 bzw. 20, 21. Die Halbleiterkörper 6 können bezüglich der Lage der Kontakte 7 und 8 ebenfalls symmetrisch zur Symmetrieachse 22 auf der Leiterbahn 3 angeordnet sein.

## Patentansprüche

1. Halbleiteranordnung mit den Merkmalen:
   a) auf einer der Seiten eines isolierenden Substrats sind mindestens zwei elektrisch voneinander getrennte, den Laststrom führende Leiterbahnen (2,3) angeordnet,
   b) die Leiterbahnen liegen einander parallel und benachbart,
   c) auf einer der Leiterbahnen (3) sind Halbleiterkörper (6) angeordnet, die über einen Kontakt mit der Leiterbahn verbunden sind,
   d) die andere Leiterbahn (2) ist elektrisch mit einem anderen Kontakt (8) des Halbleiterkörpers verbunden,
   e) zwei den Laststrom führende Anschlußleiter (11,12) sind elektrisch jeweils mit einer der beiden Leiterbahnen verbunden,
   f) die Anschlußleiter (11,12) sind dicht beieinander und mindestens teilweise parallel zueinander angeordnet und an parallel liegenden Abschnitten der Leiterbahnen (2,3) befestigt.

2. Halbleiteranordnung nach Anspruch 1 **dadurch gekennzeichnet,** daß die Anschlußleiter (11,12) rechtwinklig auf der Substratoberfläche stehen.

3. Halbleiteranordnung nach Ansruch 1 oder 2,

**dadurch gekennzeichnet,**
daß die erste (2) und die zweite Leiterbahn (3) jeweils spiegelsymmetrisch ausgebildet sind, daß die Halbleiterkörper (6) symmetrisch verteilt auf der zweiten Leiterbahn (3) angeordnet sind und daß die Anschlußleiter (11, 12) zu beiden Seiten der Symmetrieachse (22) mit den entsprechenden Leiterbahnen verbunden sind.

4. Halbleiteranordnung nach einem der Ansprüche 1 bis 3,
   **dadurch gekennzeichnet,**
   daß der Raum zwischen beiden Anschlußleitern mit einem Dielektrikum gefüllt ist, das eine relative Dielektrizitätskonstante größer als 1 hat.

5. Halbleiteranordnung nach Anspruch 4,
   **dadurch gekennzeichnet,**
   daß zwischen beiden Anschlußleitern (11, 12) eine Isolierstofffolie angeordnet ist.

## Claims

1. Semiconductor device having the following features:
   a) on one of the sides of an insulating substrate, at least two conductor tracks (2, 3) carrying the load current are arranged which are electrically isolated from one another,
   b) the conductor tracks are parallel and adjacent to one another
   c) on one of the conductor tracks (3), semiconductor bodies (6) are arranged which are connected to the conductor track via a contact,
   d) the other conductor track (2) is electrically connected to another contact (8) of the semiconductor body,
   e) two connecting conductors (11, 12) carrying the load current are in each case electrically connected to one of the two connector tracks,
   f) the connecting conductors (11, 12) are arranged closely adjacently to one another and at least partially parallel to one another and attached to parallel sections of the conductor tracks (2, 3).

2. Semiconductor device according to Claim 1, characterised in that the connecting conductors (11, 12) are standing at right angles on the substrate surface.

3. Semiconductor device according to Claim 1 or 2, characterised in that the first (2) and the second conductor track (3) are in each case constructed to be mirror-symmetrical, in that the semiconductor bodies (6) are arranged symmetrically distributed on the second conductor track (3) and in that the connecting conductors (11, 12) are connected to the corresponding conductor tracks on both sides of the axis of symmetry (22).

4. Semiconductor device according to one of Claims 1 to 3, characterised in that the space between both connecting conductors is filled with a dielectric which has a relative dielectric constant of greater than 1.

5. Semiconductor device according to Claim 4, characterised in that a foil of insulating material is arranged between both connecting conductors (11, 12).

**Revendications**

1. Dispositif à semiconducteurs comprenant les caractéristiques suivantes :

   a) au moins deux voies conductrices (2,3) séparées l'une de l'autre électriquement et véhiculant le courant de charge sont disposées sur l'une des faces d'un substrat isolant,

   b) les voies conductrices sont parallèles et voisines,

   c) des corps semiconducteurs (6), qui sont raccordés par l'intermédiaire d'un contact avec la voie conductrice, sont disposés sur l'une des voies conductrices (3),

   d) l'autre voie conductrice (2) est raccordée électriquement à un autre contact (8) du corps semiconducteur,

   e) deux conducteurs de raccordement (11,12), qui véhiculent le courant de charge, sont raccordés électriquement respectivement à l'une des deux voies conductrices,

   f) les conducteurs de raccordement (11,12) sont disposés très près l'un à côté de l'autre et au moins partiellement parallèlement l'un à l'autre et sont fixés à des sections parallèles des voies conductrices (2,3).

2. Dispositif à semiconducteurs suivant la revendication 1, caractérisé par le fait que les conducteurs de raccordement (11,12) sont perpendiculaires à la surface du substrat.

3. Dispositif à semiconducteurs suivant la revendication 1 ou 2, caractérisé par le fait que la première voie conductrice (2) et la seconde voie conductrice (3) sont réalisées de manière à être respectivement symétriques, que les corps semiconducteurs (6) sont disposés en étant répartis de façon symétrique sur la seconde voie conductrice (3), et que les conducteurs de raccordement (11,12) sont raccordés, des deux côtés de l'axe de symétrie (22), aux voies conductrices correspondantes.

4. Dispositif à semiconducteurs suivant l'une des revendications 1 à 3, caractérisé par le fait que l'espace entre les deux conducteurs de raccordement est rempli par un diélectrique qui possède une constante diélectrique relative supérieure à 1.

5. Dispositif à semiconducteurs suivant la revendication 4, caractérisé par le fait qu'une feuille en matériau isolant est disposée entre les deux conducteurs de raccordement (11,12).

FIG 1

EP 0 277 546 B1

# FIG 2